Europäisches Patentamt

European Patent Office

Office européen des brevets

(19)

(11) Publication number: **0 117 347**
**B1**

(12) **EUROPEAN PATENT SPECIFICATION**

(45) Date of publication of patent specification: **28.06.89**

(51) Int. Cl.⁴: **G 11 C 19/08**

(21) Application number: **83307381.0**

(22) Date of filing: **05.12.83**

(54) Magnetic bubble memory systems.

(30) Priority: **06.12.82 JP 212757/82**

(43) Date of publication of application:
**05.09.84 Bulletin 84/36**

(45) Publication of the grant of the patent:
**28.06.89 Bulletin 89/26**

(84) Designated Contracting States:
**DE FR GB**

(56) References cited:
**DE-A-3 034 274**

**IEEE TRANSACTIONS ON COMPUTERS, vol.
C-29, no. 11, November 1980, pages 957-970,
IEEE, New York, US; K.L. DOTY et al.:
"Magnetic bubble memory architectures for
supporting associative searching of relational
databases"**

(73) Proprietor: **FUJITSU LIMITED
1015, Kamikodanaka Nakahara-ku
Kawasaki-shi Kanagawa 211 (JP)**

(72) Inventor: **Takai, Sakan
c/o Fujitsu-shataku B-206, 100 Idasanmai-cho
Nakahara-ku Kawasaki-shi Kanagawa 211 (JP)**
Inventor: **Iida, Takenori
Haitsu Terashima 101 1886-1 Nakagawa-cho
Kohoku-ku Yokohama-shi Kanagawa 223 (JP)**
Inventor: **Kaneko, Keiichi
867, Kamikodanaka Nakahara-ku
Kawasaki-shi Kanagawa 211 (JP)**

(74) Representative: **Fane, Christopher Robin King
et al
HASELTINE LAKE & CO. Hazlitt House 28
Southampton Buildings Chancery Lane
London, WC2A 1AT (GB)**

Courier Press, Leamington Spa, England.

EP 0 117 347 B1

## Description

The present invention relates to magnetic bubble memory systems, more particularly to a major-minor construction magnetic memory system in which single-page mode access or multi-page mode access can be selected for each magnetic bubble device in the system.

In general, there are two types of memory constructions of magnetic bubble memory systems: single-loop construction and major-minor loop construction.

In major-minor loop type magnetic bubble memory systems, there are two access methods: a single-page mode which can access single pages in a minor loop in the magnetic bubble device and a multi-page mode which can access two or more pages in a minor loop in the magnetic bubble device upon one access command.

Magnetic bubble memory systems comprise one or more magnetic bubble devices, each of which has several bubble storage minor loops. In a prior art magnetic bubble memory system, however, only one of the above access methods can be used for the devices at one time, i.e. all of the magnetic bubble devices are uniformly accessed by either the single-page or multi-page mode. When a magnetic bubble memory system is set for single-page mode access, the response of bubble devices intended for. multi-page mode access becomes slow. When the system is set for multi-page mode access, the response of bubble devices intended for single-page mode access becomes slow. Therefore such prior art magnetic bubble memory systems may not provide satisfactory overall response.

It is an object of the invention to improve the accessing capabilities of such memory devices.

According to the present invention there is provided a magnetic bubble memory system comprising a magnetic bubble memory device having a read major line, a write major line and a plurality (n) of minor loops for storing pages of data, each page comprising n bits occupying respective positions in the n loops, each minor loop having a write gate for transferring data from the write line to the minor loop and a read gate for transferring data from the minor loop to the read line, which memory device can be read in either a single page access mode, or a multipage access mode in which pages of data are read in sequence without gaps therebetween, the system being characterised by:

page allocation designating means arranged to produce signals for designating whether the device is to be read in the single page access mode or the multipage access mode; and

control signal generating means coupled to the page allocation designating means and to the memory device and responsive to said signals from the page allocation designating means to control the transfer of data between the minor loops and the write line so as to set the distance between bits of consecutive pages in each minor loop at $N_1$ bits for the multipage access mode and $N_1'$ bits for the single page access mode, where $N_1$ is the number of bits along the read line between the first and the last minor loops and where $N_1' = N_1 + N_2$, where $N_2$ is the number of bits between the read gate of the first minor loop and a detector for reading the data, whereby the memory system is selectively adapted for each access mode.

Thus, embodiments of the present invention can make use of the following technical proposals; a) to allocate pages in the minor loops in each bubble memory device in accordance with the single-page mode access or multi-page mode access, b) to install an access-mode-designating circuit for each bubble memory device, and c) to construct a control circuit so as to generate a signal controlling the single-page mode access or the multi-page mode access in response to a signal from the access-mode-designating circuit.

Reference will now be made, by way of example, to the illustrations presented in the accompanying drawings, in which:

Fig. 1 is a block diagram of the bubble memory system;

Fig. 2a to 2d are views of the bubble transfer in the minor loop in Fig. 1 by multi-page mode access;

Fig. 3a to 3c are timing charts of the bubble transfer of Fig. 2;

Fig. 4a to 4d are views of the bubble transfer in the minor loop in Fig. 1 by single-page mode access;

Fig. 5a to 5c are timing charts of the bubble transfer of Fig. 4;

Fig. 6 is a circuit diagram of a bubble memory system in accordance with an embodiment of the present invention;

Fig. 7 is a detailed circuit diagram of a counter circuit, bubble device, and page-allocation-designating circuit in Fig. 6;

Figs. 8a and 8b are page allocations for multi-page mode access and single-page mode access in an embodiment of the present invention, respectively;

Figs. 9a to 9d show the transfer of bubbles in the minor loop under a read operation in an embodiment of the present invention;

Figs. 10a to 10c are timing charts of Figs. 9a to 9c; and

Fig. 11 is another embodiment of the counter circuit in Fig. 7.

Before describing a preferred embodiment of the present invention, an explanation will be given of the prior art for reference.

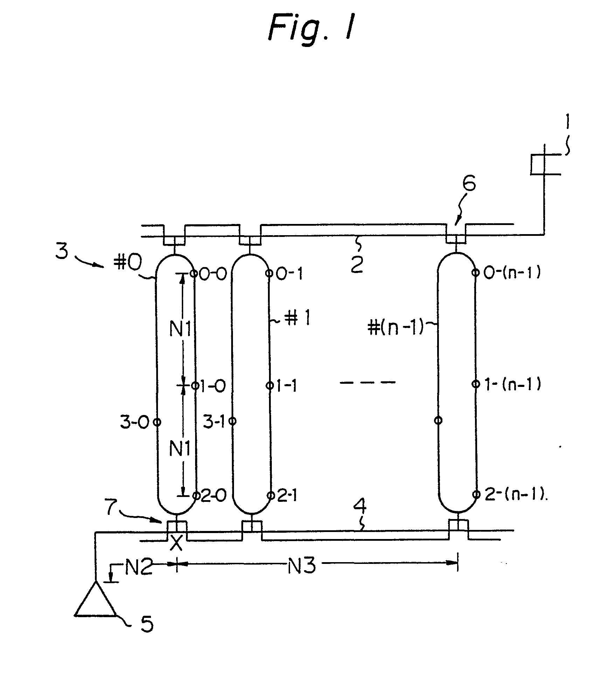

Figure 1 shows a prior art magnetic bubble device construction having major loops and minor loops. In Fig. 1, the magnetic bubble device includes storage loop 3 consisting of several minor loops #0 to #(n−1), each of which minor loops stores information in the form of a magnetic bubble, a storage major line 2, and a read major line 4.

To store information in the minor loops in the bubble device, a generator 1 generates magnetic bubbles under a command from a control circuit (not shown in Fig. 1). The generated magnetic bubbles corresponding to one page are transferred to the storage major loop 2 and stored in the minor loops #0 to #(n−1) through transfer gates (information storage gates) 6. The above transfer of the magnetic bubbles is performed by a rotational magnetic field formed by two perpendicularly intersecting coils (not shown in Fig. 1).

To read out information, replicator gates (information read gates) 7 reproduce each bit of the magnetic bubbles in each minor loop on the read major line 4. The magnetic bubbles transferred on the read major line 4 are then detected by a detector 5.

As mentioned earlier, the storage loop 3 consists of a plurality of n minor loops #0 to #(n−1), each of which has a length of N bits.

One page, for example page "0" consists of "0−0" in loop #0 to "0−(n−1)" in loop #(n−1), i.e., one page has n bits. Therefore, the total storage capacity of the storage loop 3 is N · N bits. In Fig. 1, the length of the minor loop #0 between the numerals 0−0 and 1−0 has $N_1$ bits. Lengths between other adjacent pages similarly have $N_1$ bits. The other minor loops #1 to #(n−1) feature the same construction.

The length from point X to the detector 5 corresponds to $N_2$ bits. In this length, the magnetic bubbles can be transferred and enlarged. In addition, the length of the major line between the replicator gate at the minor loop #0 and the replicator gate at the loop #(n−1) is $N_3$ bits. In the illustrated example of the prior art, $N_1$ is 580 bits, $N_2$ is 100 bits, and $N_3$ equals $N_1$.

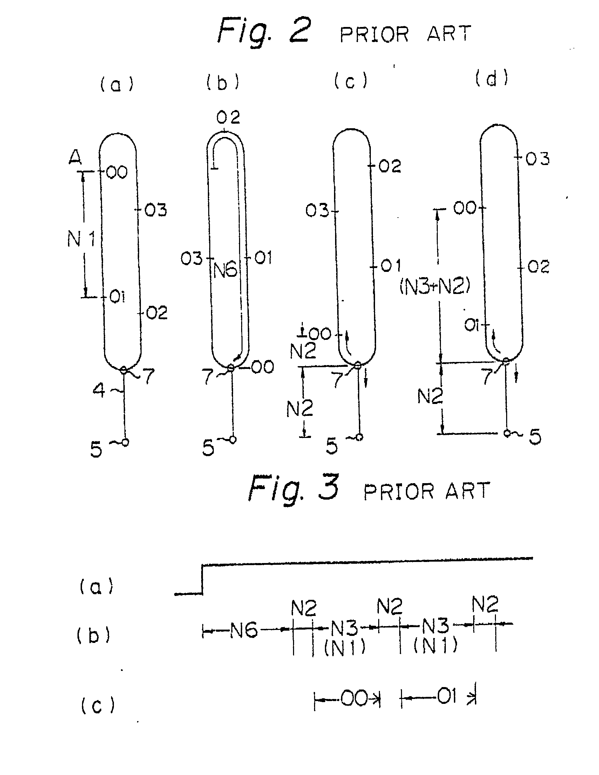

Below, the read operation of the prior art will be explained in reference to Figs. 2a to 2d and 3a to 3d and the case where all of the data in the minor loops are read under multi-page mode access. Figures 2a to 2d show only the minor loop #0. Figure 3a shows a magnetic bubble transfer signal which is high when the transfer operation has been effected. Fig. 3b shows the transfer bits, and Fig. 3c shows the pages to be read.

Assuming the first address of the page is positioned at point A as shown Fig. 2a, the magnetic bubbles in the loop #0 are circulated in the loop by $N_6$ bits until the first address reaches the replicator gate 7 (Fig. 2b). The magnetic bubbles of page 00 are reproduced at the replicator gates 7 and then transferred on the major line 4 by $N_2$ bits. When the reproduced bubble corresponding to the loop #0 reaches the detector 5, the read operation starts (Fig. 2c). The reproduced magnetic bubbles of other loops #1 to #(n−1) are then continuously shifted by $N_3$ bits on the major line 4 until all of the bits in page 00 are read. During the above operation, the magnetic bubbles in the minor loops are circulated in their loops.

When the bubble outputted from the loop #(n−1) reaches the replicator gate 7 of the loop #0, the first address of page 01 in the loop #0 has already reached the replicator gate 7 of the loop #0 (Fig. 2d). Accordingly, the bubbles of page 01 are also subjected to replication and read-out. The succeeding pages are also read in a similar manner as mentioned above.

As mentioned above, when all of the storage data in the minor loops is read by multi-page mode access, a time-consuming initial transfer of $N_6$ bits is needed for each of the minor loops, however, the succeeding page accesses can be effected at the minimum time as shown in Figs. 3a to 3c. In other words, the multi-page mode access decreases the total access time when the access operation is over two pages.

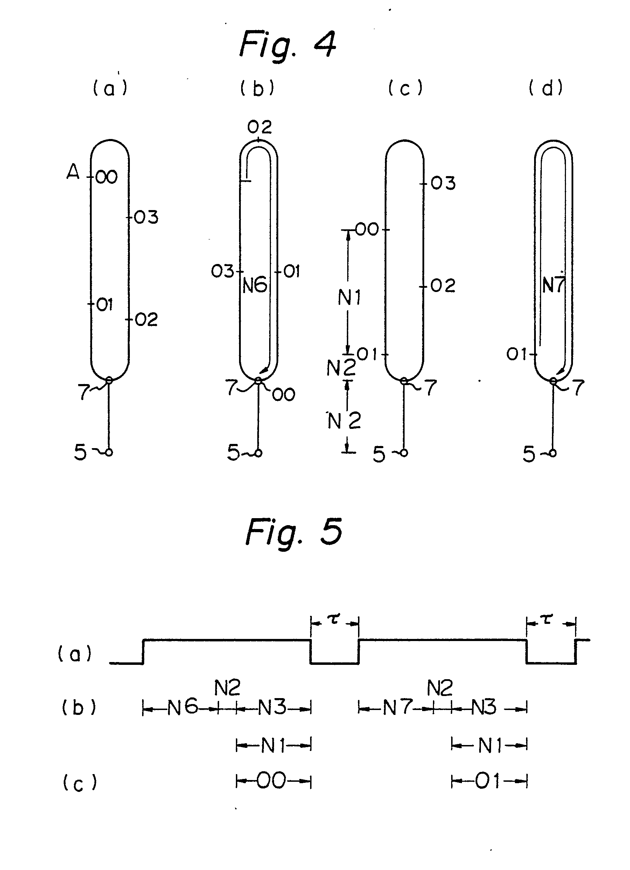

Next, the read operation of the prior art will be explained in reference to Figs. 4a to 4d and 5a to 5c and the case where all of the data in the minor loops is read under single-page mode access. Figures 4a to 4d are similar to Fig. 2a to 2d, and Figs. 5a to 5c are similar to Fig. 3a to 3c.

The initial condition of the pages in the loop #0 in Fig. 4a is the same as that in Fig. 2a. When read command to page 00 is generated, the initial $N_6$ bit transfer of the bubbles is effected so that the bit of the page 00 reaches the replicator gate 7 (Fig. 4b). $N_2$ bits of the magnetic bubbles are then further transferred so that the bit of page 00 reaches the detector 5. Accordingly, the read operation of page 00 starts. $N_3$ bits of the bubbles are then continuously transferred until the read operation of page 00 is completed.

Since the single-page mode access is used, the transfer of the magnetic bubbles is then terminated. Therefore, the starting address of page 01, whose data are not yet transferred on the read major line 4, is advanced to the portion $N_2$ bits past the replicator gate 7 of the minor loop #0 (Fig. 4c).

When the read command to page 01 occurs after the time τ from the completion of the page 00 readout, the starting address of page 01 must be circulated by $N_7$ bits=$(N−N_2)$ bits before the read operation can be effected (Fig. 4d). The read operation of the succeeding pages is effected in a similar manner.

As understood from the above, when the loop condition is set to $N_1=N_3$ so as to improve the access time and the transfer rate of the multi-page mode access, it takes more time to read several pages under single-page mode access than it takes to read those pages under multi-page mode access because there are idle times τ and $N_7$ bit circulation time every page access.

The same disadvantage is true in the storage operation under single-page mode access.

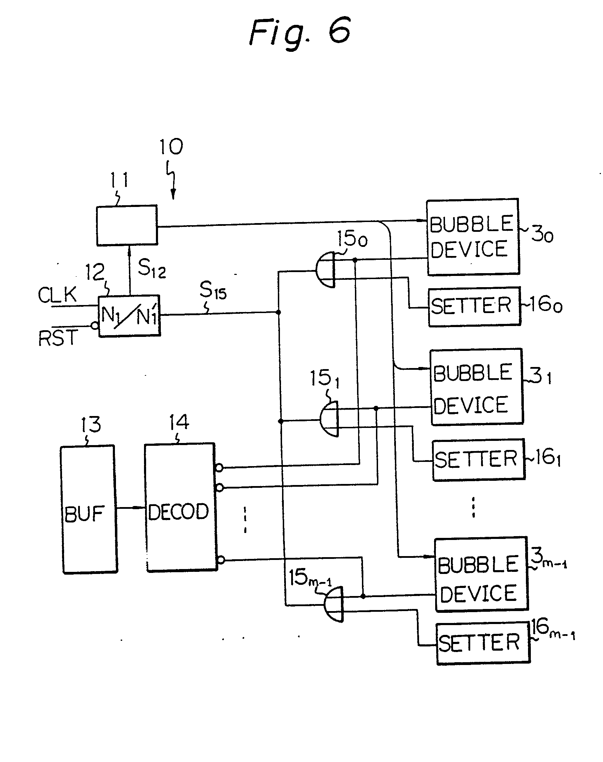

An embodiment according to the present invention will now be described with reference to Fig. 6. In Fig. 6, each magnetic bubble device $3_0$ to $3_{m−1}$ includes minor loops #0 to #(n−1) and a linear circuit.

A control circuit 10 is provided, comprising a coincidence circuit 11, a variable counting circuit 12, a device-setting buffer 13, a decoder 14, OR gates $15_0$ to $15_{m−1}$, and page-allocation-designating circuits $16_0$ to $16_{m−1}$. The control circuit 10 comprises further circuits, which, however, do not particularly concern the invention and are therefore not illustrated.

In an embodiment of the invention, access to the magnetic bubble devices is classified into the following three categories based upon the application mode:

A. Incremental accessing of a single page or a few pages, for example, when the bubble device is used for data logging,

B. Random accessing of a single page, for example, when the bubble device is used for a file memory or for general accessing, and

C. Multi-page continuous access, for example, when the bubble device is used for an initial program loader or for sequential storage data.

When the above access modes are requested simultaneously in a bubble memory system, one of the above modes is selected for each magnetic bubble device $3_0$ to $3_{m-1}$.

The mode is selected by the page-allocation-designating circuits $16_0$ to $16_{m-1}$ for the corresponding magnetic bubble devices. To select the incremental mode for the device $3_0$, the random mode for the device $3_1$, and the multi-page continuous mode for the device $3_{m-1}$, the page-allocation-designating circuits $16_0$ and $16_{m-1}$ are set to low "L" and the circuit $16_1$ to high "H".

The circuits $16_0$, $16_1$, and $16_{m-1}$ are set prior to the storage of data into the devices $3_0$, $3_1$, and $3_{m-1}$ by manual operation of mechanical switches in the circuits $16_0$ to $16_{m-1}$, automatic operation from a computer to, for example, transistors, etc.

The outputs at the designating circuits $16_0$ to $16_{m-1}$ are applied to one input terminal of the OR gates $15_0$ to $15_{n-1}$, respectively. The other input terminals of the OR gates $15_0$ to $15_{m-1}$ receive signals from the decoder 14. The outputs of the OR gates $15_0$ to $15_{m-1}$ are applied to the variable counter circuit 12, which forms a part of a control-signal generating circuit transmitting a signal controlling the transfer gates and the replicator gates in the bubble device.

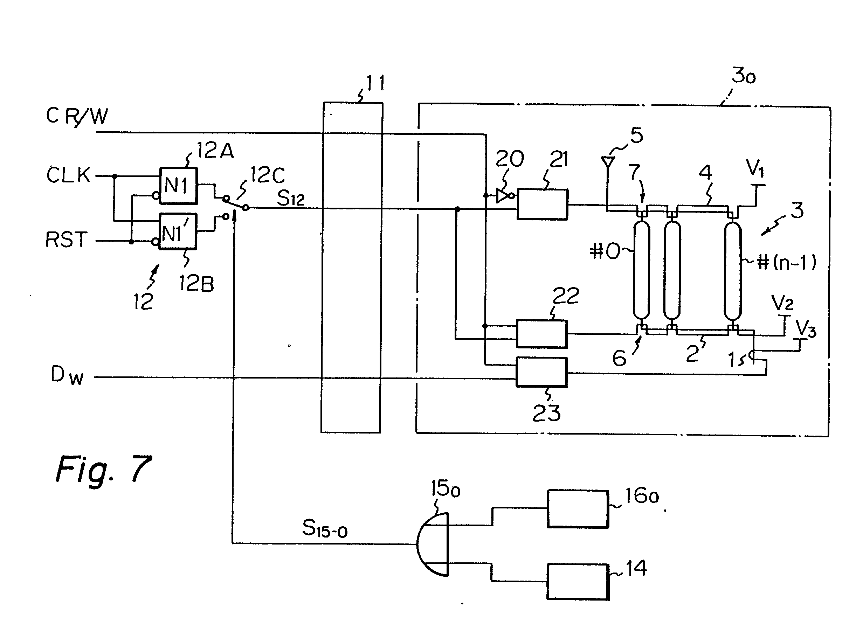

Figure 7 is a detailed diagram of the counter circuit 12, device $3_0$, OR gate $15_0$, and designating circuit $16_0$. The device $3_0$ includes a replicator driver circuit 21 and a swap gate driver circuit 22. These driver circuits 21 and 22 are connected to the read major line 4 and the storage major line 2, respectively. The write or read signal $C_{R/W}$ is inputted to the driver circuit 21 through an inverter 20 provided forward thereof and to the driver circuit 22 through the coincidence circuit 11. Therefore, one of the circuits 21 and 22 is activated in response to the signal $C_{R/W}$.

The device $3_0$ further includes a generator driver circuit 23 so as to activate the magnetic bubble generator 1 in accordance with write data $D_W$ when the signal $C_{R/W}$ is a write status. Indications $V_1$ to $V_3$ in the device $3_0$ represent the operation voltages.

The counter circuit 12 comprises two counters 12A and 12B and a switching element 12C. The counter 12A and 12B receive a clock signal CLK and output control signals having $P_1$ pulses and $P_1'$ pulses, where $P_1$ pulse corresponds to $N_1$ bits transfer of the bubbles and $P_1'$ pulse corresponds to $N_1'$ bits transfer of the bubbles. The control signal S12 is selected from the counters 12A and 12B by the switching element 12C, i.e., the control signal S12 has $P_1$ pulses when the output of the OR gate $15_0$ is high and has $P_1'$ pulses when the output is low. The control signal S12 is applied to driver circuits 21 to 23. The "RST" signal is a reset signal for the counters 12A and 12B. In this embodiment,

$P_1 = 580$ pulses ($N_1 = 580$ bits),
$P_2 = 100$ pulses ($N_2 = 100$ bits)
and
$P_1' = P_1 + P_2 = 680$ pulses
($N_1' = N_1 + N_2 = 680$ bits).

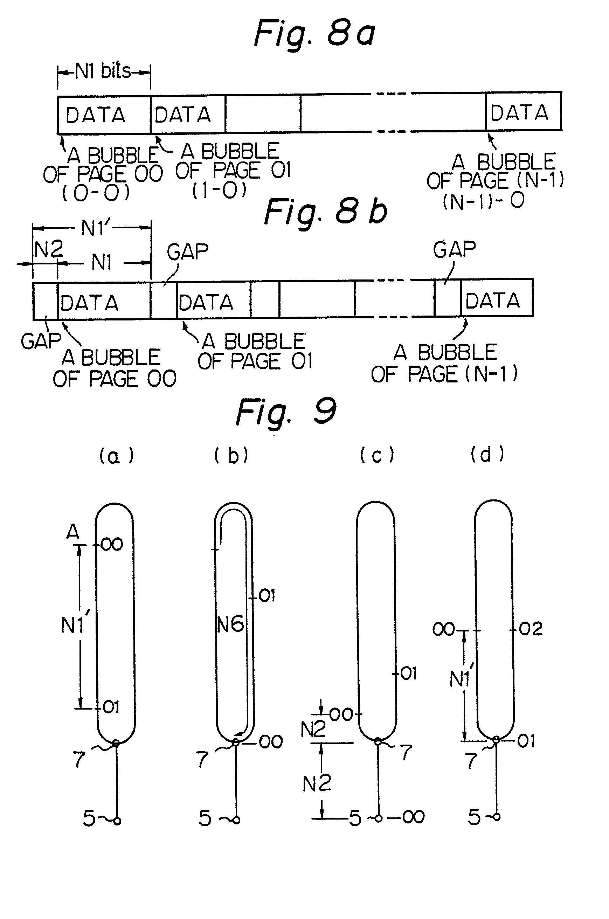

Figures 8a and 8b show page allocations in a minor loop. Figure 8a is an allocation adaptable to multi-page mode access and consists of consecutive pages. The distance between a bit of page 00 and a bit of page 01 has $N_1$ bits (DATA) which form other pages. Figure 8b is an allocation adaptable to single-page mode access. It also consists of consecutive pages, but there are additional $N_2$ bit gaps (GAP).

The operation of the bubble system in an embodiment of the present invention will be described below.

When the device buffer 13 outputs a signal to the decoder 14 to access one of the bubble devices, the decoder 14 outputs a gate signal which is low when a magnetic bubble device is to be selected, to the OR gate $15_X$ (X:0 to m−1) of the corresponding bubble device $3_X$. Therefore, the bubble device to be accessed and the access mode thereof are determined.

First, the read operation of the magnetic bubble device $3_1$ will be explained. As mentioned above, since multi-page mode access is used for the device $3_1$ and the output of the page-allocation-designating circuit $16_1$ is high, whereby the output of OR gate $15_1$ becomes high, and the output of the counter circuit 12 has $P_1$ pulse, i.e., 580 bits. This output pulse is applied to the circuits 21 to 23 in the device $3_1$ through the coincidence circuit 11 and controls the transfer of the bubbles on the read major line 4 and the transfer of the bubbles in the minor loops. This operation is similar to that of the prior art device under a multi-page mode access. Therefore, the access of the bubble device $3_1$ is effected under the most efficient condition.

Next, the read operation of the bubble device $3_0$ will be explained. As mentioned above, since single-page mode access is used for the device $3_0$ and the output of the page-allocation-designating circuit $16_0$ is low, whereby the output of OR gate $15_0$ becomes low, and the output of the counter circuit 12 has $P_1'$ pulses, i.e., 680 pulses. The device $3_0$ is activated by this signal.

Assume the initial condition of the minor loops in the device $3_0$ is that of Figs. 2 and 4, that is, the start addresses of the page "00" in the minor loops are at points A as shown in Fig. 9a. Depending on the access command, the magnetic bubbles in the minor loops are circulated by $N_6$ bits, whereby the start address reaches the replicator gates 7 as shown in Fig. 9b. The magnetic bubbles are then transferred by $N_2$ bits so that the start bubble reaches the detector 5. Therefore, the read operation of the magnetic bubbles starts as shown in Fig. 9c. As the distance between pages 00 and 01 is allocated as shown in Fig. 8b, the read operation of the page "00" will be completed by an $N_1$ bits transfer as shown in Fig. 9d.

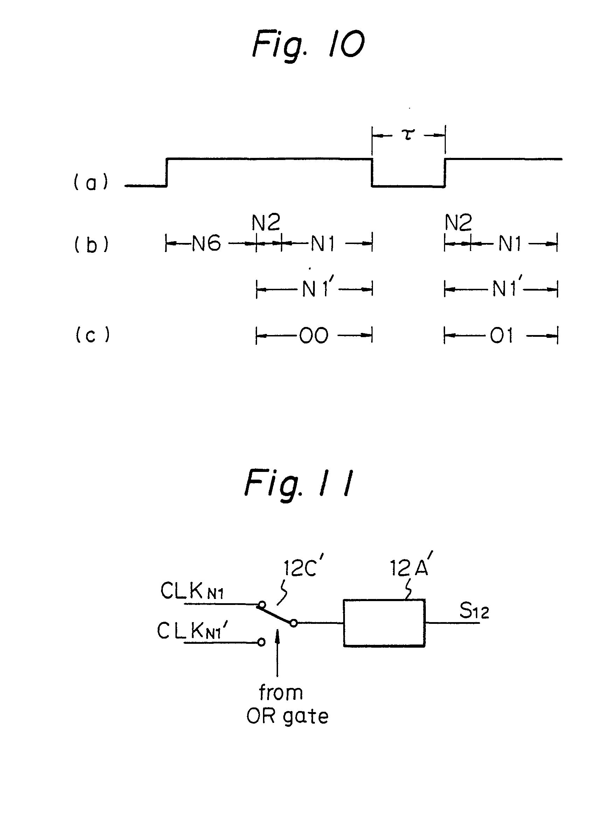

Figures 10a to 10c are timing charts of the above operation. Figure 10a shows a magnetic bubble transfer signal, which is high when the transfer is in operation, Fig. 10b shows the number of the transfer bits of the bubbles, and Fig. 10C shows the pages to be read.

In single-page mode access, the page allocation is set to $N_1'=N_1+N_2$. Therefore, the start address of page "01" is positioned at the replicator gates 7, i.e., does not pass the replicator gates 7 (Fig. 10C), as in the prior art. Therefore, when the next access request is generated after the time $\tau$ from the completion of the previous read operation, the next read operation can be effected without the waste $N_7$ bit transfer of the prior system. In other words, the operation time can be reduced by a time necessary for transfer of $N_7$ bits every page access.

The read operation of the device $3_{m-1}$ is effected under single-page mode access, therefore is similar to that of the device $3_0$ mentioned above.

The write operation is effected in a similar manner as the read operation.

In the above embodiment, the variable counter circuit 12 consists of two different counters 12A and 12B and has a clock pulse identical to that shown in Fig. 7. Various modifications of the counter circuit 12 are possible, however. For example, as shown in Fig. 11, the counter circuit 12 can be constructed by one counter 12A', and, one of two different clocks $CLK_{N1}$ and $CLK_{N1}'$ can be applied by a switching element 12C' in response to the output from one of the one OR gates 15. In this case, the clocks $CLK_{N1}$ and $CLK_{N1}'$ would have predetermined frequencies so as to output $P_1$ pulses or $P_1'$ pulses from the counter 12A'.

In an embodiment of the invention, single-page mode access and multi-page mode access can be selected for each bubble device in the bubble memory system in response to a main using mode. Thus, the operation time of the system can be reduced as compared with a prior art system.

## Claims

1. A magnetic bubble memory system comprising a magnetic bubble memory device $(3_0)$ having a read major line (4), a write major line (2) and a plurality (n) of minor loops (#0, . . ., #n−1) for storing pages of data, each page comprising n bits occupying respective positions in the n loops, each minor loop having a write gate (6) for transferring data from the write line (2) to the minor loop and a read gate (7) for transferring data from the minor loop to the read line (4), which memory device can be read in either a single page access mode, or a multipage access mode in which pages of data are read in sequence without gaps therebetween, the system being characterised by:

page allocation designating means $(16_0)$ arranged to produce signals for designating whether the device is to be read in the single page access mode or the multipage access mode; and

control signal generating means (10) coupled to the page allocation designating means and to the memory device and responsive to said signals from the page allocation designating means to control the transfer of data between the minor loops and the write line (2) so as to set the distance between bits of consecutive pages in each minor loop at $N_1$ bits for the multipage access mode and $N_1'$ bits for the single page access mode, where $N_1$ is the number of bits along the read line between the first (#0) and the last (#n−1) minor loops and where $N_1=N_1+N_2$, where $N_2$ is the number of bits between the read gate of the first minor loop (#0) and a detector (5) for reading the data, whereby the memory system is selectively adapted for each access mode.

2. A system according to claim 1, which comprises a plurality of such memory devices $(3_0-3_{m-1})$ and a corresponding plurality of such page allocation designating means $(16_0-16_{m-1})$ each page allocation designating means being arranged to set the access mode for its associated memory device.

3. A system according to any preceding claim, in which the control signal generating means is operable to emit a first number of pulses $(P_1)$ in response to one signal from the page allocation designating means and a second number of pulses $(P_2)$ in response to another signal from the page allocation designating means.

4. A system according to claim 3, in which said control-signal generating means has a first control-signal generating circuit (12A) for generating the first number of pulses, and a second control-signal generating circuit (12B) for generating the second number of pulses.

5. A magnetic bubble memory system according to claim 3, in which said control-signal generating means has a control-signal generating circuit (12A') for receiving a signal from the page allocation designating means and switch means operable to output selectively either the first or the second number of pulses.

## Patentansprüche

1. Magnetisches Blasenspeichersystem mit einer magnetischen Blasenspeichereinrichtung $(3_0)$, die eine Lesehauptleitung (4), eine Schreibhauptleitung (2) und eine Vielzahl (n) von Nebenkreisen (#0, . . ., #n−1) zum Speichern von Seiten von Daten hat, wobei jede Seite n Bits umfaßt, die entsprechende Positionen in den n-Kreisen belegen, jeder Nebenkreis ein Schreibgate (6), zum Übertragen von Daten von der Schreibleitung (2) zu dem Nebenkreis, und ein Lesegate (7), zum Übertragen von Daten von dem Nebenkreis zu der Leseleitung (4), hat, welche Speichereinrichtung entwender in einem Einzelseiten-Zugriffsmodus oder in einem Vielfachseiten-Zugriffsmodus gelesen werden kann, wobei Seiten von Daten in einer Folge ohne Spalten dazwischen gelesen werden, welches System gekennzeichnet ist durch:

Seitenzuordnungs-Bestimmungseinrichtungen ($16_0$), die angeordnet sind, um Signale zu erzeugen, welche bestimmen, ob die Einrichtung in dem Einzelseiten-Zugriffsmodus oder dem Multiseiten-Zugriffsmodus gelesen werden soll; und

eine Steuersignal-Generatoreinrichtung (10), die mit der Seitenzuordnungs-Bestimmungseinrichtung und der Speichereinrichtung verbunden ist und auf die genannten Signale von der Seitenzuordnungs-Bestimmungseinrichtung anspricht, um die Übertragung von Daten zwischen den Nebenkreisen und der Schreibleitung (2) zu steuern, um so den Abstand zwischen bits von aufeinanderfolgenden Seiten in jedem Nebenkreis bei $N_1$ Bits für den Multiseiten-Zugriffsmodus und $N_1'$ Bits für den Einzelseiten-Zugriffsmodus einzustellen, wobei $N_1$ die Anzahl von Bits längs der Leseleitung zwischen dem ersten (#0) und dem letzten (#n−1) Nebenkreis ist, und $N_1 = N_1 + N_2$, wobei $N_2$ die Anzahl von Bits zwischen dem Lesegate des ersten Nebenkreises (#0) und einem Detektor (5) zum Lesen der Daten ist, wodurch das Speichersystem selektiv für jeden Zugriffsmodus adaptiert ist.

2. System nach Anspruch 1, welches eine Vielzahl von solchen Speichereinrichtungen ($3_0$–$3_{m-1}$), und eine entsprechende Vielzahl von solchen Seitenzuordnungs-Bestimmungseinrichtungen ($16_0$–$16_{m-1}$) umfaßt, wobei jede Seitenzuordnungs-Bestimmungseinrichtung angeordnet ist, um den Zugriffsmodus für ihre zugeordnete Speichereinrichtung einzustellen.

3. System nach einem der vorhergehenden Ansprüche, bei dem die Steuersignal-Generatoreinrichtung betreibbar ist, um eine erste Anzahl von Impulsen ($P_1$) in Abhängigkeit von einem Signal von der Seitenzuordnungs-Bestimmungseinrichtung und eine zweite Anzahl von Impulsen ($P_2$) in Abhängigkeit von einem anderen Signal von der Seitenzuordnungs-Bestimmungseinrichtung zu emittieren.

4. System nach Anspruch 3, bei dem die genannte Steuersignal-Generatoreinrichtung eine erste Steuersignal-Generatorschaltung (12A) zum Erzeugen der ersten Anzahl von Impulsen, und eine zweite Steuersignal-Generatorschaltung (12B) zum Erzeugen der zweiten Anzahl von Impulsen umfaßt.

5. Magnetblasenspeichersystem nach Anspruch 3, bei dem die genannte Steuersignal-Generatoreinrichtung eine Steuersignal-Generatorschaltung (12A') zum Empfangen eines Signals von der Seitenzuordnungs-Bestimmungseinrichtung und eine Schalteinrichtung umfaßt, die betreibbar ist, um selektiv entweder die erste oder die zweite Anzahl von Impulsen auszugeben.

## Revendications

1. Système de mémoire à bulles magnétiques comportant un dispositif de mémoire à bulles magnétiques ($3_0$) comprenant une ligne majeure de lecture (4), une ligne majeure d'écriture (2) et plusieurs (n) boucles mineures (#0, . . ., #n−1) pour mémoriser des pages de données, chaque page comprenant n bits occupant des positions respectives dans les n boucles, chaque boucle mineure comprenant une porte d'écriture (6) pour transférer des données depuis la ligne d'écriture (2) vers la boucle mineure et une porte de lecture (7) pour transférer des données depuis la boucle mineure vers la ligne de lecture (4), ce dispositif à mémoire pouvant être lu dans un mode d'accès à une seule page ou dans un mode d'accès à pages multiples dans lequel des pages de données sont lues en séquence sans intervalle entre elles, le système étant caractérisé en ce qu'il comporte:

un dispositif de désignation d'affectation de pages ($16_0$) agencé pour produire des signaux qui désignent si le dispositif doit être lu dans un mode d'accès à une seule page ou dans le mode d'accès à pages multiples; et

un dispositif générateur de signaux de commande (10) couplé avec le dispositif de désignation d'affectation de pages et avec le dispositif de mémoire et réagissant auxdits signaux provenant du dispositif de désignation d'affectation de pages en commandant le transfert de données entre les boucles mineures et la ligne d'écriture (2) afin de régler la distance entre des bits de pages consécutives dans chaque boucle mineure à $N_1$ bits pour le mode d'accès à pages multiples et $N_1'$ bits pour le mode d'accès à une seule page, où $N_1$ est le nombre des bits le long de la ligne de lecture entre la première (#0) et la dernière (#n−1) boucles mineures et où $N_1 = N_1 + N_2$, où $N_2$ est le nombre des bits entre la porte de lecture de la première boucle mineure (#0) et un détecteur (5) qui lit les données, de manière que le système de mémoire soit adapté sélectivement pour chaque mode d'accès.

2. Système selon la revendication 1, comportant plusieurs de ces dispositifs de mémoire ($3_0$–$3_{m-1}$) et un nombre correspondant de ces dispositifs de désignation d'affectation de pages ($16_0$–$16_{m-1}$), chaque dispositif de désignation d'affectation de pages étant agencé pour introduire le mode d'accès pour son dispositif de mémoire associé.

3. Système selon l'une quelconque des revendications précédentes, dans lequel le dispositif générateur de signaux de commande a pour fonction d'émettre un premier nombre d'impulsions ($P_1$) en réponse à un signal provenant du dispositif de désignation d'affectation de pages et un second nombre d'impulsions ($P_2$) en réponse à un autre signal provenant du dispositif de désignation d'affectation de pages.

4. Système selon la revendication 3, dans lequel ledit dispositif générateur de signaux de commande comporte un premier circuit générateur de signaux de commande (12A) qui produit le premier nombre d'impulsions et un second circuit générateur de signaux de commande (12B) qui produit le second nombre d'impulsions.

5. Système de mémoire à bulles magnétiques selon la revendication 3, dans lequel ledit dispositif génératur de signaux de commande comporte un circuit générateur de signaux de commande (12A') pour recevoir un signal provenant du dispositif de désignation d'affectation de pages et un dispositif de commutation ayant pour fonction d'émettre sélectivement le premier ou le second nombre d'impulsions.

# Fig. 1

## Fig. 2 PRIOR ART

(a)        (b)        (c)        (d)

## Fig. 3 PRIOR ART

(a)

(b)    |—N6—|  |—N3—|  |—N3—|
              N2  (N1)  N2  (N1)  N2

(c)        |—OO→|  |—O1→|

# Fig. 4

(a)　　　(b)　　　(c)　　　(d)

# Fig. 5

(a)

(b)

(c)

# Fig. 6

Fig. 7

CR/W

CLK

RST

Dw

12A  N1
12C  S12
12B  N1'
12

11

30

20  21
5
7  4  V1
3
#0  #(n-1)
22
V2
V3
6  2'  1
23

S15-0
150
160
14

EP 0.117 347 B1

## Fig. 8a

|←N1 bits→|

| DATA | DATA | | | DATA |

A BUBBLE OF PAGE OO (O-O)

A BUBBLE OF PAGE O1 (1-O)

A BUBBLE OF PAGE (N-1) (N-1)-O

## Fig. 8b

| GAP | DATA | DATA | | | GAP | DATA |

GAP

A BUBBLE OF PAGE OO

A BUBBLE OF PAGE O1

A BUBBLE OF PAGE (N-1)

## Fig. 9

(a)    (b)    (c)    (d)

# Fig. 10

(a)

(b)

(c)

# Fig. 11